# DEMANDE DE BREVET EUROPEEN

(11) **EP 1 109 304 A1**
(43) Date de publication de la demande: **20.06.2001**
(21) Numéro de dépôt: 00811153.6
(22) Date de dépôt: 06.12.2000
(51) Int. Cl.: H02N 2/06, H02N 2/14

(54) **Circuit d'alimentation pour moteur piézo-électrique**

(30) Priorité: 09.12.1999 FR 9915550
(71) Demandeur: Metabole Development et Conseil, 74300 Cluses (FR)
(72) Inventeur: Grehant, Bernard, 74300 Nancy-sur-Cluses (FR)
(74) Mandataire: Meylan, Robert Maurice

(57) **Abrégé**

Circuit d'alimentation pour moteurs piézo-électrique à onde progressive ou stationnaire comprenant un circuit résonnant série, un élément de commutation (T1) en parallèle au condensateur C du circuit résonnant et un moyen de commande (O) de l'élément de commutation assurant sa fermeture cyclique à une fréquence proche de la fréquence de résonance du circuit résonnant. Il comprend un transformateur (Tr) dont le primaire constitue l'inductance du circuit résonnant et le secondaire est relié à l'excitateur piézo-électrique, ce transformateur présentant au primaire une faible inductance magnétique. Cette alimentation a notamment pour avantage un échauffement quasi nul de l'élément de commutation et une faible consommation de courant.

## Description

L'invention a pour objet un circuit d'alimentation pour moteurs piézo-électriques à onde progressive ou stationnaire comprenant une source de tension alimentant un circuit constitué d'une inductance en série avec, d'une part, un condensateur et, d'autre part, un élément unique de commutation en parallèle au condensateur, et un moyen de commande de l'élément de commutation assurant sa fermeture cyclique à une fréquence proche de la fréquence de résonance de l'élément piézo-électrique.

De très nombreux montages ont été proposés pour l'alimentation et la commande des excitateurs piézo-électriques destinés à alimenter des moteurs à onde progressive ou à onde stationnaire.

Dans les brevets US 4 339 682 et 4 562 374, il est ainsi proposé d'utiliser deux sources de courant alternatif déphasées de 90°.

Dans le brevet US 4 510 411, les tensions d'alimentation des deux voies d'un moteur piézo électrique à onde progressive sont obtenues à la sortie de montages amplificateurs comportant un nombre important d'interrupteurs commandés nécessaires à l'alimentation des deux voies. Des circuits d'alimentation du même type sont utilisés dans les circuits de commande selon les brevets US 5 021 700 et 5 130 619. Dans ces deux documents, on relève également le nombre important d'interrupteurs commandés. Il en est encore de même du dispositif de commande selon le brevet US 5 625 246 qui utilise en outre deux transformateurs. Les alimentations commercialisées sous la marque SHINSEI pour alimenter les moteurs de type USR30, USR45 et USR60 comportent ainsi un transformateur et deux transistors MOS par voie. Les transistors doivent commuter le courant sous une tension relativement importante et ils sont par conséquent montés sur un dissipateur de chaleur pour limiter leur échauffement.

Dans une alimentation très simplifiée avec transformateur, décrite dans la demande de brevet WO 95/34097, on utilise un seul élément de commutation pour les deux voies d'alimentation du moteur, mais cette disposition requiert l'usage d'un enroulement primaire supplémentaire, avec diode, pour la démagnétisation du circuit magnétique, selon le montage dit "forward". Ces circuits comportent aussi la particularité de grouper les deux voies sur un même transformateur à deux secondaires, en utilisant un quadripôle sur un des circuits secondaires pour provoquer le déphasage recherché de 90°. Comme dans les circuits précédemment cités, le transistor constituant l'interrupteur ne commute ni à courant zéro, ni à tension zéro, ce qui provoque son échauffement, échauffement nécessitant une évacuation de la chaleur produite. Si on souhaite utiliser ce montage "forward" tout en imposant, comme c'est généralement le cas, un déphasage de 90° à partir des signaux de commande, deux voies d'alimentations séparées sont nécessaires, avec deux transformateurs séparés, chacun comportant au primaire un bobinage principal relié à chaque élément de commutation et une bobinage de désaimantation destiné à empêcher l'apparition d'une composante continue de forte valeur, qui provoquerait la dégradation du fonctionnement du circuit d'alimentation. Dans tous les cas, le bobinage de désaimantation comporte autant de spires que le bobinage principal, ce qui représente un encombrement et un coût que l'on préférerait éviter.

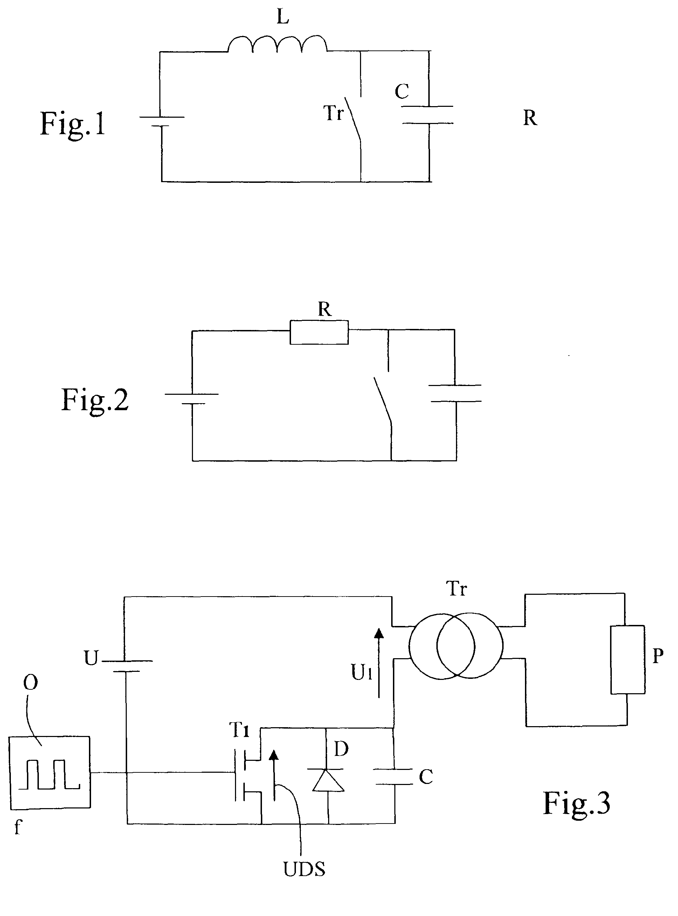

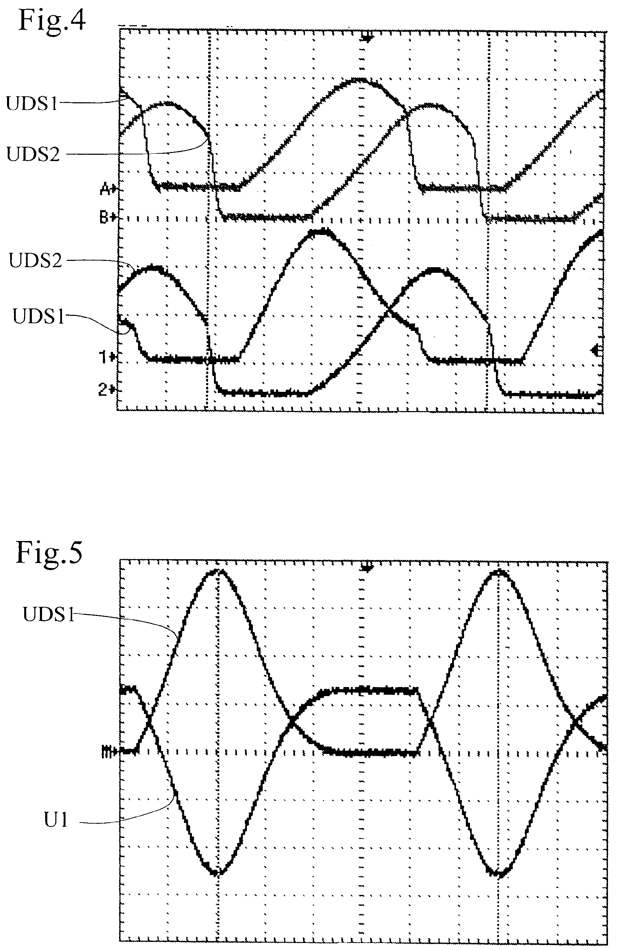

Dans le brevet US 5 179 311 est décrit un circuit d'alimentation dans lequel une haute tension cyclique est générée au moyen d'un convertisseur à résonance. Le principe général d'alimentation à résonance est décrit, par exemple, dans l'ouvrage "POWER-ELECTRONICS" Converters, Applications and Design édité par John Wiley & Sons, Inc, deuxième Edition, par Mohan, Undeland et Robbins, page 271 à 273. Si l'on considère la figure 2 du brevet US 5 179 311, on constate, de manière simplifiée, en se plaçant à la fréquence de l'excitateur piézo électrique, qu'il s'agit d'alimenter à travers une bobine d'inductance LO une charge R montée en parallèle avec un condensateur de capacité CO et un élément de commutation piloté à une fréquence proche de la fréquence de résonance du circuit LO/CO. Afin d'obtenir une tension proche de la sinusoïde et d'amplitude suffisante, il est proposé (figure 4) d'ajouter une deuxième inductance en série avec la charge et de maintenir le caractère résonnant de l'alimentation par un condensateur en parallèle avec le transistor de commutation. Il est certain que la valeur élevée des tensions à appliquer à chaque voie et la volonté de se rapprocher en sortie d'une tension sinusoïdale, nécessitent en pratique des inductances élevées et donc l'usage de bobines à noyau ferrite. Dans ces conditions, deux bobines se revèlent au moins aussi encombrantes et coûteuses qu'un transformateur à deux enroulements, lequel présente, comme ceci est connu, l'avantage d'une isolation galvanique, souvent fort utile, entre primaire et secondaire.

On peut se demander pourquoi il n'a pas été fait usage de transformateur dans une telle alimentation à résonance, ni par Suganuma (US 5 179 311), ni par d'autres inventeurs. On constate au contraire que Suganuma, qui revient malgré tout à l'utilisation d'un transformateur dans le brevet postérieur US 5 625 246, paraît avoir renoncé à insérer ce transformateur dans une structure à résonance et reprend les montages classiques de l'art antérieur.

### Les raisons paraissent être les suivantes :

Si on branche le primaire d'un transformateur en parallèle sur l'interrupteur (transistor), on obtient bien l'isolation galvanique recherchée, mais avec à nouveau le besoin d'un bobinage supplémentaire de démagnétisation, car le primaire du transformateur est soumis à une composante continue importante. Cette solution ne présente donc aucun avantage économique.

Il venait également à l'esprit d'utiliser le primaire d'un transformateur comme inductance du circuit résonnant. Une telle solution est représentée schématiquement à la figure 1 du dessin annexé où L désigne le primaire du transformateur, Tr l'interrupteur. Que se passe-t-il dans une tel circuit? Il est connu qu'un transformateur normalement dimensionné absorbe au primaire un courant à vide faible, voire négligeable, relativement au courant absorbé au primaire lorsque le secondaire alimente une charge. En première approximation, le courant primaire est proportionnel au courant secondaire, avec un coefficient égal au rapport du nombre de spires (N1.I1 = N2.I2). En vertu d'une propriété connue d'adaptation d'impédance, l'impédance vue du primaire est celle de la charge divisée par le carré du rapport de transformation N2/N1. La charge ohmique R du transformateur se trouve ainsi ramenée au primaire. Cette charge représente une résistance équivalente de plus faible valeur si le transformateur est élévateur de tension. Cette résistance équivalente vient courtcircuiter l'inductance primaire du transformateur, de telle sorte que le fonctionnement du circuit n'est plus du tout celui d'une alimentation à résonance comme ceci est représenté à la figure 2 du dessin annexé. Une telle structure se semblait donc pas pouvoir être retenue.

L'invention a, malgré tout, pour but de réaliser une alimentation à résonance utilisant un transformateur simple de manière à assurer une isolation galvanique du moteur par rapport au reste du circuit d'alimentation, mais conservant son caractère résonant.

Le circuit d'alimentation selon l'invention est caractérisé en ce qu'il comprend un transformateur dont le primaire constitue l'inductance et le secondaire est relié à l'excitateur piézo-électrique, ce transformateur présentant au primaire une faible inductance magnétique caractérisée en ce que le surcroît de courant absorbé à pleine charge est toujours inférieur au courant total absorbé à vide, et en ce que le dimensionnement de cette inductance et le choix du condensateur sont déterminés de manière à obtenir une commutation au voisinage du zéro de tension pour la fréquence de travail du circuit.

Du brevet JP 01107681 il est certes connu d'alimenter un moteur piézo-électrique au moyen de deux transformateurs et de huit transistors de commutation, c'est-à-dire quatre transistors par voie, selon une configuration classique.

Le but de cette alimentation est cependant très différent : il s'agit de pouvoir alimenter, dans les meilleurs conditions de rendement, un moteur raccordé à une source de basse tension telle qu'une pile électrique, tout en permettant un contrôle de la vitesse sur une plage étendue, alors que le circuit selon l'invention n'utilise qu'un seul composant actif par voie et qu'il n'est prévu qu'un seul point de fonctionnement du moteur. L'inventeur de l'alimentation selon le document JP 01107681 ne s'est pas soucié du nombre de composants de commutation.

Contrairement aux transformateurs usuels, le courant magnétisant, dans le circuit selon l'invention, est supérieur au courant de transformation imposé par la charge ramenée au primaire.

Une diode de roue libre, c'est-à-dire montée en inverse, sera généralement montée en parallèle à l'élément de commutation, mais on verra par la suite qu'il est possible de se passer d'une telle diode. Par ailleurs, si l'élément de commutation est un transistor MOS, la jonction PN intrinsèque vue entre source et drain peut suffir à remplacer la diode de roue libre. De même, la capacité CDS intrinsèque du transistor, vue entre source et drain, peut suffir à remplacer le condensateur.

La commutation du transistor se faisant à tension zéro ou presque, l'échauffement du transistor est pratiquement nul. Avantageusement, un entrefer important est ménagé sur le circuit magnétique du transformateur. Cet entrefer vise ici à diminuer très sensiblement l'inductance magnétisante Lm du transformateur, ce qui a pour effet d'augmenter son courant magnétisant Io. Il en résulte que, contrairement au dimensionnement normal des transformateurs, le courant magnétisant est ici de l'ordre, voire bien supérieur, au courant de transformation imposé par la charge ramenée au primaire.

Le dessin annexé représente, à titre d'exemple, un mode d'exécution de l'invention.

La figure 3 représente le schéma général d'un circuit d'alimentation de l'une des voies d'un moteur piézo-électrique.

La figure 4 est l'enregistrement des tensions aux bornes des transistors d'une alimentation à deux voies d'un exemple d'exécution pour une fréquence d'alimentation supérieure à la fréquence de résonance.

La figure 5 est l'enregistrement des mêmes tensions pour une fréquence proche de la fréquence de résonance.

La figure 6 est l'enregistrement des courants dans une voie.

Le circuit est alimenté par une source de tension continue U. Le circuit résonant est constitué du primaire d'un transformateur Tr et d'un condensateur C. L'élément de commutation est constitué d'un transistor T1 de type MOS dont le drain est relié au point commun du condensateur et du primaire du transformateur et la source est reliée au point négatif de la source de courant continu U. La grille de T1 est reliée à un oscillateur O appliquant une tension cyclique de commande de fréquence f au transistor T1. Le secondaire du transformateur Tr est relié aux bornes d'un excitateur piézo-électrique P du moteur. Une diode D , dite de roue libre, est montée en inverse en parallèle au transistor T1 et au condensateur C.

Le transformateur Tr présente une structure en deminoyaux de ferrite. Un entrefer précis est obtenu en disposant une feuille de matériau amagnétique tel que papier ou Mylar (marque déposée) entre les noyaux au moment du montage du transformateur.

Lorsque la charge P n'est pas branchée aux bornes du secondaire du transformateur, le caractère résonant du montage est complètement déterminé par la valeur C du condensateur et l'inductance magnétisante Lm du transformateur. En raison de la faible inductance magnétisante du transformateur, le caractère résonant reste largement dominé par ces valeurs quand le secondaire alimente la charge P. Ainsi, même en charge, le schéma équivalent au schéma de la figure 3 reste, en première approximation, celui de la figure 1.

On s'arrange, notamment par le choix de l'entrefer et/ou celui C, pour que la fréquence du circuit série Lm/C soit légèrement inférieure à la fréquence de pilotage de l'élément piézo-électrique. Pour des raisons de stabilité, exposées dans l'art antérieur cité, la fréquence de pilotage est elle-même légèrement supérieure à la fréquence de résonance électromécanique du moteur.

L'alimentation de la deuxième voie du moteur est réalisée de la même manière.

Afin de mieux comprendre comment il est possible, par le calcul, la simulation ou les essais, d'optimiser la forme d'onde, on a représenté en figure 4, les relevés des tensions UDS aux bornes d'une alimentation à deux voies. Les tensions de commande de l'élément de commutation sont ici déphasées de 90°. La voie 1, A alimente un excitateur P, tandis que l'autre voie 2, B est à vide.

Un premier enregistrement A, B est réalisé à une fréquence d'alimentation plus élevée que la fréquence de résonance de l'excitateur P. Celui-ci n'absorbe donc que très peu de courant et les deux voies sont identiques. Les paliers horizontaux correspondent aux temps de conduction des transistors. Comme ceci est connu de la littérature, au moment où un transistor cesse de conduire, le courant qui le traversait passe cette fois dans le condensateur qui voit sa tension augmenter avec une pente d'autant plus importante que ce courant était important.

Pour le deuxième enregistrement 1, 2, la fréquence d'alimentation s'est rapprochée de la fréquence de résonance de l'excitateur P. On constate très nettement que cela n'a pas de conséquence sur la tension UDS2, c'est-à-dire la tension de la voie dont le secondaire est à vide, alors que la tension UDS1 de la voie pour laquelle le secondaire est en charge, augmente plus rapidement du fait de l'incidence du courant de transformation qui, bien que faible, s'ajoute au courant de l'inductance Lm. On constate aussi que la commutation à l'ouverture de T1 est plus favorable que celle de T2 : à tension plus faible correspondent donc des pertes plus faibles.

Le meilleur rendement est obtenu lorsque la commutation du transistor se produit au zéro de tension. Ce fonctionnement optimisé est représenté à la figure 5. Les tensions enregistrées sont la tension UDS1 et la tension U1 aux bornes du primaire du transformateur pour la fréquence d'alimentation nominale. On constate que U1 ne présente effectivement pas de composante continue.

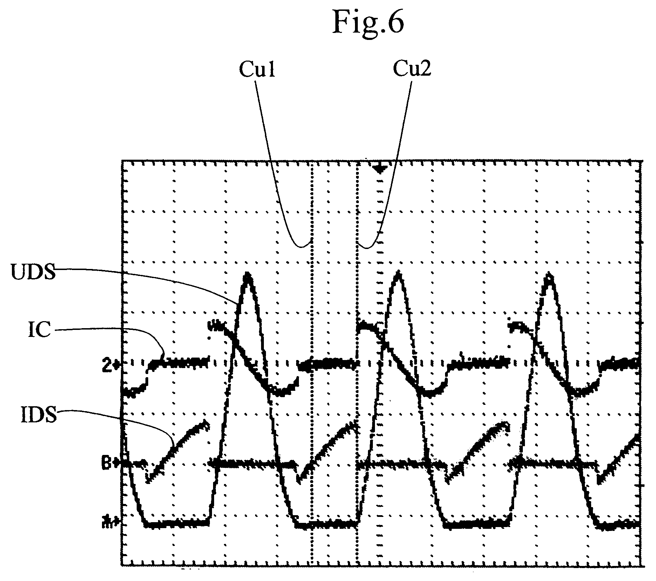

L'enregistrement représenté à la figure 6 montre la tension UDS aux bornes de l'alimentation, le courant IDS dans l'alimentation, c'est-à-dire le courant traversant le transistor, et le courant dans le condensateur C. Cet enregistrement montre qu'il serait ici judicieux de diminuer la pente à l'origine de la tension UDS et donc le palier horizontal, pour se rapprocher encore d'une sinusoïde. Il est possible d'agir à sa guise sur C, en l'augmentant, ou sur Lm, en jouant sur le nombre de spires du transformateur ou sur l'entrefer.

Le palier horizontal de UDS est ici plus long que le simple temps de conduction commandée du transistor, matérialisé par les deux curseurs verticaux Cu1 et Cu2. On a une phase pendant laquelle UDS vaut en fait -0,6V: c'est la diode D qui assure alors la conduction. Si le dimensionnement temporel est bien fait, cette phase n'a pas lieu et D est inutile. Si T1 est un transistor MOS, sa diode intrinsèque suffit à jouer ce rôle. La figure 6 illustre aussi qu'on aurait eu intérêt à diminuer également le temps de conduction commandée du transistor, de manière à se rapprocher encore d'une tension sinusoïdale. Pour une fréquence donnée, cette diminution doit s'accompagner d'une augmentation de la période naturelle du circuit résonant Lm, C si on désire conserver une commutation au zéro de tension.

La superposition du courant IC dans le condensateur C et du courant IDS dans le transistor donne le courant dans le transformateur, courant d'allure sinusoïdale. En fait, ce dernier possède une composante continue, dont le produit par la tension d'alimentation donne la puissance transmise, aux pertes près, à la charge. Mais cette valeur est faible relativement à la composante alternative et de plus, du fait de l'entrefer, le transformateur ne travaille pas dans une zone de saturation. Le bobinage de démagnétisation d'une structure "Forward" est donc totalement inutile.

On constate que l'alimentation à résonance n'utilise qu'un courant faible par rapport au courant traversant les composants.

Dans le montage utilisé, le courant magnétisant Io est plus de huit fois supérieur aux valeurs que l'on rencontre dans un transformateur conventionnel.

Alors qu'on pouvait s'attendre à ce que le circuit selon l'invention soit pénalisé par la circulation dans les composants d'un courant résonnant supérieur, voire très supérieur, au courant utile, c'est tout le contraire qui se produit dans les montages expérimentés. Les pertes de commutation étant ici quasiment nulles, et les composants MOS présentant de bonnes performances en conduction, il est inutile de recourir aux dissipateurs montés sur des montages MOS classiques en demi-pont destinés à alimenter les mêmes moteurs. Le rendement de l'alimentation est excellent, ce qui n'est pas le moindre de ses avantages.

Il faut enfin relever que la structure selon l'invention utilisant un transformateur de faible inductance magnétisante primaire s'accorde bien avec un montage très fortement élévateur de tension, comme dans le cas d'un système autonome raccordé à quelques éléments de batterie. Un tel système requiert un rapport très élevé du nombre de spires, ce qui conduit de façon réaliste à un faible nombre de spires au primaire, ce qui va dans le sens voulu d'une faible inductance magnétisante. Dans ce cas, l'entrefer est inutile, voire préjudiciable à un bon coefficient de qualité de montage.

## Revendications

1. Circuit d'alimentation pour une voie de moteur ou d'actionneur piézo-électrique résonnant comprenant une source de tension alimentant un circuit constitué d'une inductance en série avec, d'une part, un condensateur (C) et, d'autre part, un élément unique de commutation (t1) en parallèle au condensateur, et un moyen de commande (O) de l'élément de commutation assurant sa fermeture cyclique à une fréquence proche de la fréquence de résonance de l'élément piézo-électrique, caractérisé en ce qu'il comprend un transformateur (Tr) dont le primaire constitue l'inductance et dont le secondaire est relié à l'excitateur piézo-électrique, ce transformateur présentant au primaire une faible inductance magnétique caractérisée en ce que le surcroît de courant absorbé à pleine charge est toujours inférieur au courant à vide, et en ce que le dimensionnement de cette inductance et le choix du condensateur sont déterminés de manière à obtenir une commutation au voisinage du zéro de tension pour la fréquence de travail du circuit.

2. Circuit d'alimentation selon la revendication 1, caractérisé en ce qu'il comprend une diode de roue libre (D) en parallèle à l'élément de commutation.

3. Circuit d'alimentation selon la revendication 1 ou 2, caractérisé en ce que le transformateur est muni d'un entrefer.

4. Circuit d'alimentation selon la revendication 2 dans lequel l'interrupteur est constitué d'un transistor MOS, caractérisé en ce que la diode de roue libre est constituée par la jonction PN intrinsèque entre la source et le drain du transistor.

5. Circuit d'alimentation selon l'une des revendications 1 à 4 dans lequel l'interrupteur est constitué d'un transistor MOS, caractérisé en ce que le condensateur est constitué par la capacité intrinsèque du transistor MOS.
